# EUROPEAN PATENT APPLICATION

(11) **EP 3 057 146 A1**
(43) Date of publication of application: **17.08.2016**
(21) Application number: 14847612.0
(22) Date of filing: 09.09.2014
(51) Int. Cl.: H01L 37/02, C01G 33/00, H02N 2/18, H02N 11/00

(54) **POWER GENERATION MATERIAL, POWER GENERATION ELEMENT AND POWER GENERATION SYSTEM**

(30) Priority: 30.09.2013 JP 2013205183
(71) Applicant: Daihatsu Motor Co., Ltd., Ikeda-shi, Osaka 563-8651 (JP); National University Corporation Nagaoka University of Technology, Nagaoka-shi Niigata 940-2188 (JP)
(72) Inventor: KIM, Juyoung, Gamo-gun, Shiga 520-2531 (JP); KIM, Yoonho, Gamo-gun, Shiga 520-2531 (JP); OGAWA, Takashi, Gamo-gun, Shiga 520-2531 (JP); YAMANAKA, Satoru, Gamo-gun, Shiga 520-2531 (JP); NAKAJIMA, Akira, Gamo-gun, Shiga 520-2531 (JP); TANAKA, Hirohisa, Gamo-gun, Shiga 520-2531 (JP); NAKAYAMA, Tadachika, Nagaoka-shi, Niigata 940-2188 (JP); TAKEDA, Masatoshi, Nagaoka-shi, Niigata 940-2188 (JP); YAMADA, Noboru, Nagaoka-shi, Niigata 940-2188 (JP); NIIHARA, Koichi, Nagaoka-shi, Niigata 940-2188 (JP)
(74) Representative: Zimmermann, Tankred Klaus
(86) International application number: PCT/JP2014/073724
(87) International publication number: WO 2015/045841

(57) **Abstract**

Provided are a power generation element including a power generation material indicated by the following general formula (1), and a power generation system using the power generation element: (AₓB₁₋ₓ)NbO₃ (1), where A and B are mutually different and represent at least one element selected from rare-earth elements, alkaline-earth metals, alkaline metals, Cd, and Bi, and x represents an atomic proportion in a numerical range of 0 < x ≤ 1. The configuration provides a power generation material that enables sufficient power generation performance even in a high temperature range, a power generation element including the power generation material, and a power generation system using the power generation element.

## Description

### TECHNICAL FIELD

The present invention relates to a power generation material, a power generation element, and a power generation system. Specifically, the present invention relates to a power generation material, a power generation element including the power generation material, and a power generation system using the power generation element.

### BACKGROUND ART

Typically, large amounts of thermal energy are emitted and lost in the form of exhaust heat and light, for example, in various energy utilizing devices, such as internal combustion engines including automobile engines; heat exchangers including boilers and air conditioning equipment; electric engines including electric generators and motors; and light-emitting devices for illumination and the like.

In recent years, there is growing demand to collect and reuse the emitted thermal energy as an energy source, from the viewpoint of energy conservation.

For example, one specific method proposes a power generation system provided with a heat source of which the temperature is increased and decreased over time, a first device, and a second device. As the temperature of the heat source changes, the temperature of the first device is increased and decreased over time so as to include at least a part of a temperature range of from -20°C with respect to the Curie point to +10°C with respect to the Curie point. In this way, the first device is electrically polarized, and electric power is obtained from the first device by the second device. It is also proposed to use, as the first device, a bulk-type piezo element (structure: Nb and Sn-added PZT (Nb/Sn/Pb (Zr,Ti)O₃), the Curie point 315°C) (see, for example, Patent Document 1).

Using higher-temperature heat sources in such power generation systems has also been considered.

However, the Curie point of the Nb and Sn-added PZT (Nb/Sn/Pb (Zr,Ti)O₃) described in the cited Patent Document 1 is 315°C. In temperature ranges above the Curie point, sufficient power generation performance cannot be obtained. As a result, it may not be possible to use a high-temperature heat source.

### CITATION LIST

### PATENT DOCUMENT

Patent Document 1: JP-A-2013-51862

### SUMMARY OF THE INVENTION

### PROBLEMS TO BE SOLVED BY THE INVENTION

In view of the above-described problems, an object of the present invention is to provide a power generation material that enables sufficient power generation performance to be obtained in a high temperature range, a power generation element including the power generation material, and a power generation system using the power generation element.

### SOLUTION TO THE PROBLEMS

In order to achieve the object, according to an aspect of the present invention, there is provided a power generation material characterized by the following general formula (1):

(AₓB₁₋ₓ)NbO₃ (1)

where A and B are mutually different and represent at least one element selected from rare-earth elements, alkaline-earth metals, alkaline metals, Cd, and Bi, and x represents an atomic proportion in a numerical range of 0 < x ≤ 1.

According to a preferred aspect of the present invention, there is provided a power generation material wherein, in the general formula (1), A is K; B is Na; and x is 1/2.

According to another aspect of the present invention, there is provided a power generation element including the power generation material.

According to another aspect of the present invention, there is provided a power generation system including a heat source of which a temperature is increased and decreased over time; a first device including the power generation element and configured to be electrically polarized by the temperature change of the heat source; and a second device for obtaining electric power from the first device.

### EFFECTS OF THE INVENTION

The power generation element including the power generation material, and the power generation system provided with the power generation element can provide sufficient power generation performance even in a high temperature range (for example, 315°C or higher).

The objects, features, aspects, and advantages of the present invention will become apparent from the following detailed description and the attached drawings.

### BRIEF DESCRIPTION OF THE DRAWINGS

FIG. 1 is a schematic diagram of an embodiment of a power generation system according to the present invention.
FIG. 2 illustrates XRD data of a power generation element according to Example 1.
FIG. 3 illustrates XRD data of a power generation element according to Example 2.
FIG. 4 shows a FE-SEM image of the power generation element according to Example 1.
FIG. 5 shows a graph indicating the Curie point of the power generation element according to Example 1.
FIG. 6 shows a graph indicating the relationship between the generated voltage obtained by the power generation element according to Example 1 and temperature change.

### DESCRIPTION OF THE EMBODIMENTS

A power generation material according to the present invention is expressed by the following general formula (1):

(AₓB₁₋ₓ)NbO₃ (1)

where A and B are mutually different elements and represent at least one element selected from rare-earth elements, alkaline-earth metals, alkaline metals, Cd, and Bi; and x represents an atomic proportion in a numerical range of 0 < x ≤ 1.

In the general formula (1), A and B are mutually different elements and represent at least one element selected from rare-earth elements, alkaline-earth metals, alkaline metals, Cd, and Bi.

In the general formula (1), examples of the rare-earth elements indicated by A and B include La (lanthanum), Ce (cerium), Pr (praseodymium), Yb (ytterbium), and Lu (lutetium). Preferable examples include La (lanthanum) and Ce (cerium).

Examples of the alkaline-earth metals A and B include Be (beryllium), Mg (magnesium), Ca (calcium), Sr (strontium), and Ba (barium). Preferable examples include Ca (calcium), Sr (strontium), and Ba (barium).

Examples of the alkaline metals A and B include Li (lithium), Na (sodium), K (potassium), Rb (rubidium), and Cs (cesium).

The above elements may be used individually, or two or more of the elements may be used in combination.

Preferably, A and B may be both alkaline metals. More preferably, A may be K and B may be Na.

In the general formula (1), x is the atomic proportion of A and indicates a numerical range of 0 < x ≤ 1 and preferably a numerical range of 1/3 ≤ x ≤ 1. In other words, A is an essential component, of which the atomic proportion is more than zero and preferably not less than 1/3 and not more than 1.

The atomic proportion of B is the remaining atomic proportion obtained according to 1 - x; namely, by subtracting the atomic proportion of A (0 < x ≤ 1) from 1. Thus, in the general formula (1), B is an arbitrary component which may or may not be included.

Specific examples of the power generation material indicated by the general formula (1) include LaNbO₃, LiNbO₃, KNbO₃, MgNbO₃, CaNbO₃, (K_{1/2}Na_{1/2})NbO₃, (Bi_{1/2}K_{1/4}Na_{1/4})NbO₃, (Sr_{1/100}(K_{1/2}Na_{1/2})_{99/100})NbO₃, (Ba_{1/100} (K_{1/2}Na_{1/2})_{99/100})NbO₃, and (Li_{1/10} (K_{1/2}Na_{1/2})_{9/10})NbO₃.

Preferable examples of the power generation material include power generation materials in which A and B in the general formula (1) are both alkaline metals. Particularly preferably, in the general formula (1), A may be K; B may be Na; and x may be 1/2. Among the power generation materials, K_{1/2}Na_{1/2}NbO₃ may be cited as a particularly preferable example. With K_{1/2}Na_{1/2}NbO₃, high generation efficiency can be obtained.

The power generation material may be manufactured by known methods. From the obtained power generation material, a power generation element can be manufactured.

More specifically, for example, carbonate oxides of various atoms (for example, K₂CO₃, Na₂CO₃, and Nb₂O₅ when K_{1/2}Na_{1/2}NbO₃ is to be manufactured) are mixed to achieve the stoichiometric ratio so as to prepare a precursor powder. The mixing method is not particularly limited. For example, a known wet-type mixing method may be used.

The obtained precursor powder is subjected to a heat treatment. For example, the heat treatment involves heating the precursor powder from normal temperature at a constant temperature-increase rate, and holding the powder at a predetermined attainment temperature for a predetermined time.

For example, the temperature-increase rate is 2°C/min or higher and not higher than 10°C/min and preferably 4°C/min or higher and not higher than 8°C/min.

The attainment temperature may be, for example, 800°C or higher and not higher than 1100°C, and preferably 850°C or higher and not higher than 1000°C. The holding time at the attainment temperature may be, for example, one hour or longer and not longer than 24 hours, and preferably 2 hours or longer and not longer than 12 hours.

Thereafter, the precursor powder after the heat treatment is dry-mixed by a known method and pulverized as needed.

In this method, the powder after the heat treatment may be mixed with a binder as needed.

The binder is not particularly limited. Examples of the binder include polytetrafluoroethylene (PTFE), polyvinyl acetate, polyethylene oxide, polyvinyl ether, polyvinylidene fluoride (PVdF), fluoroolefin copolymer crosslinked polymer, fluoroolefin vinyl ether copolymer crosslinked polymer, polyvinylpyrrolidone, polyvinyl alcohol, polyacrylic acid, and polyvinyl butyral (PVB). Preferable examples include polyvinyl alcohol and polyvinyl butyral (PVB).

The binder may be used individually, or two or more binders may be used in combination.

The compounding ratio of the binder relative to a total amount of 100 parts by mass of the powder after the heat treatment and the binder may be 0.01 part by mass or greater and 0.9 part by mass or smaller, and preferably 0.04 part by mass or greater and 0.1 part by mass or smaller.

The obtained powder (or the mixture of the powder and binder as needed) is compression-molded into a desired shape and then sintered.

The compression molding and sintering may involve hot pressing method or pulse electric current sintering (PECS) method.

For example, when hot pressing method is adopted, the molding pressure as a processing condition may be 10 MPa or higher and not higher than 200 MPa, and preferably 30 MPa or higher and not higher than 100 MPa. The sintering temperature may be 950°C or higher and not higher than 1150°C, and preferably 1050°C or higher and not higher than 1125°C. The holding time at those temperatures may be one hour or longer and not longer than 12 hours, and preferably 2 hours or longer and not longer than 8 hours.

When the pulse electric current sintering method is adopted, the molding pressure as a processing condition may be 10 MPa or higher and not higher than 200 MPa, and preferably 30 MPa or higher and not higher than 100 MPa. The sintering temperature may be 800°C or higher and not higher than 1100°C, and preferably 850°C or higher and not higher than 1000°C. The holding time at those temperatures may be one minute or longer and not longer than one hour, and preferably 3 minutes or longer and not longer than 30 minutes.

By the above-described methods, the precursor powder can be sintered while simultaneously being compression-molded.

Other than the methods described above, the precursor powder may be initially compression-molded, and then sintered separately.

The molding conditions during compression molding are not particularly limited. The molding pressure may be 10 MPa or higher and not higher than 200 MPa, and preferably 30 MPa or higher and not higher than 100 MPa. The molding time may be one minute or longer and not longer than 10 minutes, and preferably 3 minutes or longer and not longer than 5 minutes.

During compression molding, known molding machines, such as a single-axis press molding machine and a CIP molding machine (cold isostatic pressure pressing machine) may be used individually or in combination.

Preferably, the powder after the heat treatment is first compression-molded by the single-axis press molding machine. The compression molding is performed, for example, at 10 MPa or higher and not higher than 100 MPa and preferably at 30 MPa or higher and not higher than 50 MPa, and for one minute or longer and not longer than 10 minutes, and preferably 3 minutes or longer and not longer than 5 minutes. Thereafter, compression molding by the CIP molding machine is further performed. The compression molding is performed, for example, at 30 MPa or higher and not higher than 200 MPa and preferably at 50 MPa or higher and not higher than 100 MPa, for one minute or longer and not longer than 10 minutes, and preferably 3 minutes or longer and not longer than 5 minutes.

Thereafter, in this method, the obtained molding is sintered by a known sintering device.

Among the sintering conditions, the sintering temperature may be 850°C or higher and not higher than 1300°C, and preferably 900°C or higher and not higher than 1250°C. The holding time at those temperatures may be one hour or longer and not longer than 48 hours, and preferably 2 hours or longer and not longer than 24 hours.

In this method too, the precursor powder can be compression-molded and sintered.

In this way, the power generation material indicated by the general formula (1) can be obtained, and a power generation element including the power generation material can be obtained.

In this method, the obtained power generation material (power generation element) may be further subjected to an anneal process. For example, the anneal process may involve holding the power generation material (power generation element) at a predetermined temperature for a predetermined time.

The temperature condition of the anneal process may be 800°C or higher and not higher than 1100°C, and preferably 900°C or higher and not higher than 1000°C. The holding time at those temperatures may be one hour or longer and not longer than 24 hours, and preferably 2 hours or longer and not longer than 12 hours.

By such anneal process, the purity of the power generation material (power generation element) can be increased, and improvements in physical stability and chemical stability can be achieved.

The power generation element may contain a power generation material other than the power generation material indicated by the general formula (1), or an oxide (for example, Nb₂O₅) and the like, to the extent that the excellent effect of the present invention will not be hindered.

The shape of the power generation element is not particularly limited. Examples of the shape that may be selected include a thin film (sheet) and a disc.

The size of the power generation element is not particularly limited. When the power generation element is formed in a substantially rectangular thin film, the length of one side may be 0.5 mm or longer and not longer than 30 mm, and preferably 10 mm or longer and not longer than 15 mm. The thickness may be 0.1 mm or longer and not longer than 5 mm, and preferably 0.2 mm or longer and not longer than 1 mm.

When the power generation element is formed in disc shape, the diameter of the disc may be 5 mm or greater and not greater than 30 mm, and preferably 10 mm or greater and not greater than 30 mm. The thickness may be 0.1 mm or greater and not greater than 5 mm, and preferably 0.2 mm or greater and not greater than 1 mm.

The power generation material may have a specific permittivity of not lower than 500 and preferably not lower than 1000, and not higher than 25000 and preferably not higher than 20000.

The Curie point (the temperature at which the permittivity rapidly changes) of the power generation material may be 150°C or higher and not higher than 500°C, and preferably 200°C or higher and not higher than 450°C.

The power generation material may have a plurality of (two or more) Curie points.

When there is a plurality of Curie points, the highest Curie point may be 350°C or higher and not higher than 500°C, and preferably 400°C or higher and not higher than 450°C.

The lowest Curie point may be 150°C or higher and not higher than 300°C, ad preferably 200°C or higher and not higher than 250°C.

The power generation element according to the present invention including the power generation material according to the present invention has the above-described Curie points. Accordingly, the power generation element can provide sufficient power generation performance even in a high temperature range (for example, 315°C or higher).

Accordingly, the power generation element according to the present invention can be used in a power generation system as a piezo element or a pyroelectric element, for example.

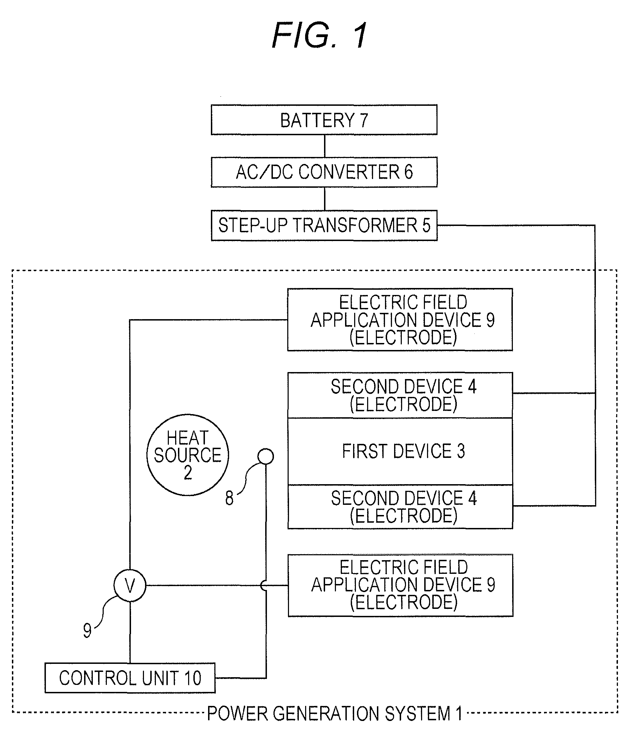

FIG. 1 is a schematic diagram of an embodiment of the power generation system according to the present invention.

Referring to FIG. 1, the power generation system 1 is provided with a heat source 2 of which the temperature is increased and decreased over time; a first device 3; a second device 4 for obtaining electric power from the first device 3; a temperature sensor 8 as a sense means for sensing the temperature of the first device 3; an electric field application device 9 as an electric field application means for applying an electric field to the first device; and a control unit 10. As the temperature of the heat source 2 is changed, the temperature of the first device 3 increases and decreases over time. As a result, the first device 3 is electrically polarized. The control unit 10 is a control means for activating the electric field application device 9 when the temperature sensed by the temperature sensor 8 is equal to or higher than the Curie point of the first device 3.

The heat source 2 is not particularly limited besides it being a heat source of which the temperature is increased and decreased over time. The heat source may include various energy utilizing devices, such as an internal combustion engine and a light-emitting device.

The internal combustion engine is a device that outputs power for vehicles, for example. The internal combustion engine may include a single-cylinder type or multi-cylinder type device. The single-cylinder or multi-cylinder device may have adopted a multi-cycle system (for example, 2-cycle system, 4-cycle system, or 6-cycle system).

In such internal combustion engines, upward and downward movements of a piston are repeated in each cylinder. For example, in a 4-cycle system, the intake stroke, the compression stroke, the expansion stroke, and the exhaust stroke are successively executed. In this way, fuel is combusted to produce power that is output.

In the exhaust stroke of an internal combustion engine, high-temperature exhaust gas is exhausted via an exhaust gas pipe. Using the exhaust gas as a heat medium, thermal energy is transmitted. Accordingly, the internal temperature of the exhaust gas pipe is increased.

In the other strokes (other than the exhaust stroke), the amount of exhaust gas in the exhaust gas pipe is decreased. Accordingly, the internal temperature of the exhaust gas pipe is decreased compared with the temperature during the exhaust stroke.

Thus, the temperature of the internal combustion engine is increased during the exhaust stroke and decreased in the intake stroke, the compression stroke, and the expansion stroke. In other words, the temperature of the internal combustion engine increases and decreases over time.

Particularly, the respective strokes are periodically successively repeated in accordance with the piston cycle. Accordingly, inside the exhaust gas pipe of each cylinder of the internal combustion engine, the temperature periodically varies in accordance with the period of repetition of the various strokes. More specifically, a high temperature state and a low temperature state are periodically repeated.

The temperature of a light-emitting device is increased by, for example, the thermal energy of light as a heat medium, such as infrared light or visible light, when the device is turned on (to emit light). On the other hand, when turned off, the temperature decreases. Accordingly, the temperature of the light-emitting device increases and decreases over time as the device is turned on (to emit light) and off over time.

Particularly, for example, when the light-emitting device is a light-emitting device that repeats the turning on and off of illumination in an intermittent manner over time (a blinking (flashing) light-emitting device), the temperature of the light-emitting device is periodically changed by the thermal energy of light when turned on (emitting light). More specifically, a high temperature state and a low temperature state are periodically repeated.

The heat source 2 may be further provided with a plurality of heat sources, where the plurality of heat sources may be switched to produce a temperature change.

More specifically, for example, a low temperature heat source (such as a cooling material) and a high temperature heat source (such as a heating material) having a higher temperature than the low temperature heat source may be prepared as a heat source, and the two heat sources may be alternately switched.

In this way, the temperature of the heat source can be increased and decreased over time. Particularly, the switching of the low temperature heat source and the high temperature heat source may be periodically repeated so as to produce a periodic temperature change.

The heat source 2 provided with a plurality of switchable heat sources is not particularly limited. Examples include a low temperature air supply system for combustion; a regenerative heat exchanger; a high temperature gas exhaust system; a high temperature air combustion furnace equipped with a supply/exhaust switch valve (for example, a high temperature gas generate device disclosed in Re-publication of PCT International Publication No. 96-5474); and a sea-water exchange device (hydrogen storing alloy actuator-type sea-water exchange device) using, for example, a high temperature heat source, a low temperature heat source, and a hydrogen storing alloy.

As the heat source 2, the above-described heat sources may be used individually, or two or more of the heat sources 2 may be used in combination.

A preferable example of the heat source 2 is a heat source of which the temperature periodically changes over time.

A preferable example of the heat source 2 is an internal combustion engine.

The first device 3 is a device that is electrically polarized in accordance with the temperature change in the heat source 2.

The electric polarization herein refers to the phenomenon in which a potential difference is caused by dielectric polarization due to displacement of positive and negative ions associated with crystal distortion. The electric polarization may be defined, for example, as a phenomenon in which electromotive force is produced in a material, such as the piezo effect and/or a phenomenon, such as the pyroelectric effect, in which a potential difference is caused by a permittivity change due to a temperature change.

More specific examples of the first device 3 include a device that is electrically polarized by the piezo effect, and a device that is electrically polarized by the pyroelectric effect.

The piezo effect is an effect (phenomenon) in which, when stress or distortion is applied, electric polarization is caused in accordance with the magnitude of the stress or distortion.

In the power generation system 1, as the first device 3 ("piezo element" (piezoelectric element)) that is electrically polarized by the piezo effect, the above-described power generation element (preferably K_{1/2}Na_{1/2}NbO₃) may be used.

When a piezo element is used as the first device 3, the piezo element is disposed, for example, in contact with (exposed to) the heat source 2 or a heat medium that transmits the heat of the heat source 2 (such as the above-described exhaust gas or light), with the surroundings of the element being fixed by a fixing member so as to suppress volume expansion.

The fixing member is not particularly limited. For example, the second device 4 (such as a gold electrode or a silver electrode), which will be described below, may be used.

In this case, the piezo element is expanded or contracted by being heated or cooled by the temporal temperature change in the heat source 2 (via, in some cases, a heat medium (such as the above-described exhaust gas or light)).

At this time, the piezo element has its volume expansion suppressed by the fixing member. Accordingly, the piezo element is pressed onto the fixing member. And the piezo element is electrically polarized by the piezo effect (piezoelectric effect), or a phase transformation around the Curie point. As a result, as will be described below, electric power is obtained from the piezo element via the second device 4.

Such a piezo element is normally maintained in a heated state or cooled state. When its temperature becomes constant (namely, when the volume is constant), electric polarization is neutralized. Thereafter, as the element is cooled or heated, the element is again electrically polarized.

Accordingly, as the heat source 2 is subjected to the periodic temperature change, the high temperature state and the low temperature state are periodically repeated. In this case, the piezo element is periodically repeatedly heated and cooled. Thus, the electric polarization of the piezo element and its neutralization are periodically repeated.

As a result, electric power is obtained by the second device 4, which will be described below, as a periodically varying waveform (for example, alternating current or pulsating current).

The pyroelectric effect is an effect (phenomenon) in which, for example, when an insulator (dielectric) or the like is heated and cooled, the insulator is electrically polarized in accordance with a temperature change thereof. The effect includes a first effect and a second effect.

The first effect is defined as an effect in which, at the time of heating and cooling an insulator, the insulator is subjected to spontaneous polarization due to a temperature change thereof, whereby charges are produced on the insulator surface.

The second effect is defined as an effect (piezo effect, piezoelectric effect) in which, at the time of heating and cooling an insulator, when a pressure deformation is caused by a temperature change thereof in the crystal structure, piezoelectric polarization is caused by the stress or distortion applied to the crystal structure.

In the power generation system 1, as the first device 3 that is electrically polarized by the pyroelectric effect (hereafter "pyroelectric element"), the above-described power generation element (preferably, K_{1/2}Na_{1/2}NbO₃) may be used.

When a pyroelectric element is used as the first device 3, the pyroelectric element is disposed in contact with (exposed to) the heat source 2 or a heat medium that transmits the heat of the heat source 2 (such as the above-described exhaust gas or light).

In this case, the pyroelectric element is heated or cooled by the temporal temperature change of the heat source 2 (via, in some cases, a heat medium, such as the above-described exhaust gas or light). By the pyroelectric effect (including the first effect and the second effect), the element is electrically polarized. As a result, as will be described below, electric power is obtained from the pyroelectric element via the second device 4.

Such a pyroelectric element is normally maintained in a heated state or cooled state. When its temperature becomes constant, electric polarization is neutralized. Thereafter, as the element is cooled or heated, the element is again electrically polarized.

Accordingly, as the heat source 2 is subjected to the periodic temperature change, the high temperature state and the low temperature state are periodically repeated. In this case, the pyroelectric element is periodically repeatedly heated and cooled. Thus, the electric polarization of the pyroelectric element and its neutralization are periodically repeated.

As a result, electric power is obtained by the second device 4, which will be described below, as a periodically varying waveform (for example, alternating current or pulsating current).

The first device 3 may be used individually, or two or more first devices 3 may be used in combination.

The first device 3 (insulator (dielectric)) is electrically polarized by the temperature change of the heat source 2. The electric polarization may be electronic polarization, ion polarization, or orientational polarization.

For example, it is hoped that an increase in generation efficiency can be achieved by changing the molecular structure of a material (such as liquid crystal material) that exhibits polarization by orientational polarization.

Referring to FIG. 1, the second device 4 is provided to obtain electric power from the first device 3.

The second device 4 is not particularly limited. More specifically, for example, the second device 4 is provided with two electrodes (such as a gold electrode and a silver electrode) disposed facing each other across the first device 3, and conductive wires connected to the electrodes. The second device 4 is also electrically connected to the first device 3.

The temperature sensor 8 is disposed adjacent to or in contact with the first device 3 so as to sense the temperature of the first device 3. The temperature sensor 8 directly senses a surface temperature of the first device 3 as the temperature of the first device 3. Alternatively, the temperature sensor 8 may sense the atmospheric temperature around the first device 3. For example, known temperature sensors may be used, such as an infrared radiation thermometer and a thermocouple thermometer.

The electric field application device 9 is disposed directly on, or adjacent to, the first device 3 so as to apply an electric field to the first device 3. Specifically, the electric field application device 9 is provided with, for example, two electrodes (such as a gold electrode and a silver electrode) disposed facing each other across the first device 3 and separately from the above-described second device 4; a voltage applying power supply V; and conductive wires connected thereto. The electric field application device 9 is disposed spaced apart from the first device 3, with the first device 3 disposed between the electrodes.

The control unit 10 is a unit, such as an electronic control unit (ECU), that performs electrical control in the power generation system 1. The control unit 10 may include a microcomputer provided with a CPU, a ROM, and a RAM, for example.

The control unit 10 is electrically connected to the temperature sensor 8 and the electric field application device 9. As will be described below, when the temperature sensed by the above-described temperature sensor 8 is equal to or higher than the Curie point of the first device 3, the electric field application device 9 is activated.

In the power generation system 1 illustrated in FIG. 1, the second device 4 is successively electrically connected to a step-up transformer 5, an alternating-current/direct-current converter (AC-DC converter) 6, and a battery 7.

In order to generate power using the power generation system 1, first, for example, the temperature of the heat source 2 is increased and decreased over time, preferably periodically. By the heat source 2, the first device 3 is heated and/or cooled.

In accordance with such temperature changes, the above-described first device 3 is electrically polarized preferably periodically. Thereafter, electric power is obtained via the second device 4 as a waveform (for example, an alternating-current or a pulsating current) that periodically varies in accordance with the periodic electric polarization of the first device 3.

Specifically, preferably, in the thermoelectric system 1, the heat source 2 causes the temperature of the first device 3 to be changed over time so as to include at least a part of the temperature range of from -20°C with respect to the Curie point to +10°C with respect to the Curie point.

When there is a plurality of Curie points in the first device 3 including the above-described power generation element, any of the Curie points may be selected.

Specifically, in the thermoelectric system 1, the temperature of the first device 3 is changed as follows. In the high temperature state, the temperature exceeds the temperature in the low temperature state, and becomes -20°C or higher with respect to the Curie point. Further, in the low temperature state, the temperature is lower than the temperature in the above-described high temperature state, and becomes +10°C or lower with respect to the Curie point.

Preferably, the temperature of the first device 3 is changed over time so as to include at least a part of the temperature range of from -18°C with respect to the Curie point to +8°C with respect to the Curie point, and more preferably to include at least a part of the temperature range of from -15°C with respect to the Curie point and to +5°C with respect to the Curie point.

Accordingly, the temperature of the first device 3 can be changed so as to not include the Curie point thereof.

Specifically, the temperature of the first device 3 can be changed, for example, so that both the temperature in the high temperature state and the temperature in the low temperature state exceed the Curie point, and so that the temperature in the low temperature state is +10°C or lower with respect to the Curie point. Further, the temperature of the first device 3 may be changed, for example, so that both the temperature in the high temperature state and the temperature in the low temperature state are lower than the Curie point, and so that the temperature in the high temperature state is -20°C or higher with respect to the Curie point.

Further, the temperature of the first device 3 may be changed so as to include the Curie point thereof; namely, so that the temperature in the high temperature state exceeds the Curie point and the temperature in the low temperature state is lower than the Curie point.

Preferably, the temperature of the first device 3 may be changed so as to include the Curie point thereof.

In the power generation system 1, normally, a greater voltage can be obtained as the amount of change in the temperature of the first device 3 is increased. When the temperature of the first device 3 increases and decreases over time so as to include at least a part of the temperature range of from -20°C with respect to the Curie point to +10°C with respect to the Curie point, a large voltage can be obtained even when the amount of temperature change is small. Accordingly, power can be generated with high efficiency.

Specifically, the temperature of the first device 3 in the low temperature state may be -40°C or higher with respect to the Curie point, preferably -30°C or higher with respect to the Curie point, and more preferably -20°C or higher with respect to the Curie point. The temperature in the high temperature state may be +30°C or lower with respect to the Curie point, preferably +20°C or lower with respect to the Curie point, and more preferably +10°C or lower with respect to the Curie point.

Thus, the temperature of the first device 3 may be particularly preferably changed in the range of from -20°C with respect to the Curie point to +10°C with respect to the Curie point.

In this case, the temperature of the first device 3 in the high temperature state may be 30 to 1200°C, preferably 100 to 800°C, and more preferably 200 to 450°C. The temperature in the low temperature state may be lower than the temperature in the high temperature state. The temperature difference between the high temperature state and the low temperature state may be 10 to 100°C and preferably 20 to 50°C.

The repetition period of the high temperature state and the low temperature state may be 1/50 to 100 cycles/s and preferably 1/20 to 50 cycles/s.

The temperature of the first device 3 can be measured using, for example, an infrared thermometer or the like.

The temperature of the heat source 2 is set in a range such that the temperature of the first device 3 can be changed in the above ranges.

More specifically, the temperature of the heat source 2 in the high temperature state may be 50 to 1200°C and preferably 200 to 900°C. The temperature in the low temperature state may be lower than the temperature in the high temperature state and more specifically 50 to 800°C and preferably 200 to 500°C. The temperature difference between the high temperature state and the low temperature state may be 10 to 600°C and preferably 20 to 500°C.

The repetition period of the high temperature state and the low temperature state may be 1/50 to 100 cycles/s and preferably 1/20 to 50 cycles/s.

Meanwhile, in the power generation system 1, depending on the temperature condition, the temperature of the first device 3 may exceed the Curie point. In addition, if the first device 3 is used in an environment of the Curie point of the first device 3 or above, the first device 3 may become damaged, whereby power generation performance may be lowered or even lost.

Accordingly, preferably, in the power generation system 1, the temperature of the first device 3 is sensed by the temperature sensor 8. When the sensed temperature is equal to or higher than the Curie point of the first device 3, the control unit 10 activates the electric field application device 9 so as to apply an electric field to the first device 3.

Specifically, the temperature of the first device 3 that increases and decreases over time due to the temperature change in the heat source 2 is sensed by the temperature sensor 8 continuously. From the point in time when the sensed temperature became equal to or higher than the Curie point of the first device 3 to the point in time when the temperature becomes lower than the Curie point, a voltage is applied to the electrodes of the electric field application device 9, and further an electric field is applied to the first device 3.

The intensity of the electric field may be 0.01 to 5 kV/mm, preferably 0.2 to 3.5 kV/mm, and more preferably 0.5 to 2 kV/mm.

From the point in time when the temperature sensed by the temperature sensor 8 became lower than the Curie point of the first device 3 to the point in time when the sensed temperature again becomes equal to or higher than the Curie point, the application of the electric field is stopped.

As a result, even when the first device 3 is exposed in an environment exceeding the Curie point thereof, damage to the first device 3 can be mitigated.

For example, when the first device 3 has a plurality of Curie points, the electric field application device 9 may be activated from when equal to or higher than the lowest Curie point to when lower than the lowest Curie point. The application of the electric field may be stopped from the point in time when lower than the lowest Curie point to when again equal to or higher than the lowest Curie point.

Even without activating the electric field application device 9, damage to the first device 3 can be mitigated by controlling the temperature of the first device 3, which increases and decreases over time, to be in a temperature range of -20°C with respect to the lowest Curie point to +10°C with respect to the lowest Curie point.

For example, depending on the timing of activation of the electric field application device 9, an increase in generation efficiency of the power generation system 1 can be achieved.

Specifically, in the power generation system 1, in order to generate power more efficiently, a voltage is applied to the first device 3 in accordance with the temperature state of the first device 3.

Thus, in the power generation system 1, along with the heating and/or cooling by the heat source 2, the temperature of the first device 3 is continuously measured by the temperature sensor 8. As a result, it is sensed whether the first device 3 is in an increased-temperature state or a decreased-temperature state. More specifically, for example, if the temperature of the first device 3 sensed by the temperature sensor 8 has increased at a pre-set predetermined value (such as 0.2°C/s) or above, the increased-temperature state is sensed. If the temperature of the first device 3 has decreased at a pre-set predetermined value (such as 0.2°C/s) or above, the decreased-temperature state is sensed.

In the power generation system 1, when it is sensed that the first device 3 is in the increased-temperature state, the voltage application device 9 is activated. Then, a predetermined voltage is applied to the first device 3. The magnitude of the voltage may be set as needed in accordance with the purpose or use. The voltage is applied for a time until the first device 3 reaches the decreased-temperature state, specifically for the time in which the first device is in the increased-temperature state.

When it is sensed that the first device 3 is in the decreased-temperature state, a control circuit 21 is switched by the control unit 10 so as to stop the voltage application device 9. The application of voltage to the first device 3 is also stopped. The voltage application is stopped for a time until the first device 3 reaches the increased-temperature state, specifically for the time in which the first device 3 is in the decreased-temperature state.

Accordingly, in the power generation system 1, the voltage application device 9 is activated when an increased temperature of the first device 3 is sensed. Then, a voltage is applied to the first device 3. On the other hand, when a decreased temperature of the first device 3 is sensed, the voltage application device 9 is stopped, and the voltage application is stopped.

By thus activating the voltage application device 9 and applying a voltage to the first device 3, electric power can be obtained from the first device 3 efficiently.

The electric power obtained by the power generation system 1 is stepped up, in the form of a periodically varying waveform (for example, an alternating-current or pulsating current), by the step-up transformer 5 connected to the second device 4. The step-up transformer 5 may include a step-up transformer capable of stepping up an alternating-current voltage with high efficiency by a simple configuration using coils and capacitors, for example.

The electric power stepped up by the step-up transformer 5 is converted into a direct-current voltage by the alternating-current/direct-current converter 6, and then stored in the battery 7.

In the power generation system 1, the temperature of the heat source 2 used increases and decreases over time. Accordingly, a varying voltage (for example, an alternating-current voltage) can be obtained. As a result, compared with when the power is obtained as a constant voltage (direct-current voltage), the power can be stepped up and stored with high efficiency by a simple configuration.

When the heat source 2 is a heat source with periodically changing temperatures, electric power can be obtained as a periodically varying waveform. As a result, the electric power can be stepped up and stored with increased efficiency by a simple configuration.

Particularly, in the power generation system 1, the temperature of the first device 3 is sensed by the temperature sensor 8. When the sensed temperature is equal to or higher than the Curie point of the first device 3, the control unit 10 activates the electric field application device 9, whereby an electric field is applied to the first device 3.

Accordingly, even when the first device 3 is exposed in an environment exceeding the Curie point thereof, damage to the first device 3 can be mitigated. As a result, a decrease in and even a loss of power generation performance of the power generation system 1 can be prevented. As a result, power can be generated with high efficiency even in a high temperature environment.

The power generation system according to the present invention is provided with the power generation element according to the present invention. Accordingly, even in a high temperature range (for example, 315°C or higher), sufficient power generation performance can be provided.

### Examples

The present invention will be described with reference to an example and a comparative example. It should be noted that the present invention is not limited to the following examples. The numerical values of the following examples may be replaced by the numerical values (upper limit value or lower limit value) according to the embodiment.

### Example 1

A powder of K₂CO₃, a powder of Na₂CO₃, and a powder of Nb₂O₅ were compounded to achieve the molar ratios of K₂CO₃: Na₂CO₃: Nb₂O₅ =1:1:2. The powders were stirred and mixed with ion-exchanged water in a wet-type ball mill (from Nikkato Corporation) using zirconia balls for 24 hours, and then dried.

The obtained powder was heated in air at a temperature-increase rate of 5°C/min. The powder was heat-treated at 880°C for 4 hours, mixed and pulverized in a dry-type ball mill (from Nikkato Corporation) using zirconia balls for 12 hours.

Then, polyvinyl alcohol as a binder was added to be 0.04 part by mass relative to a total amount of 100 parts by mass of the powder after heat treatment and the polyvinyl alcohol. This was followed by stirring and mixing in the wet-type ball mill for 2 hours.

The resultant mixture was then poured into a mold. Using a hot-press device (from Fujidempa Kogyo Co., Ltd.), heating (hot-pressing) was performed at 60 MPa and 1100°C for 2 hours, whereby a molding with a diameter of 20 mm was obtained.

Thereafter, the molding was heated in air at 900°C for 4 hours for an anneal process. In this way, a power generation material including (K_{1/2}Na_{1/2})NbO₃, and a power generation element including the power generation material were obtained.

### Example 2

A power generation material including (K_{1/2}Na_{1/2})NbO₃ and a power generation element including the power generation material were obtained by the same method as in Example 1 with the exception that, instead of the hot-press device, a spark plasma sintering machine (from SPS Syntex Inc.) was used, and that the molding was obtained by heating at 50 MPa and 920°C for 5 minutes, using pulse electric current sintering method.

### Evaluation

### 1. Composition analysis

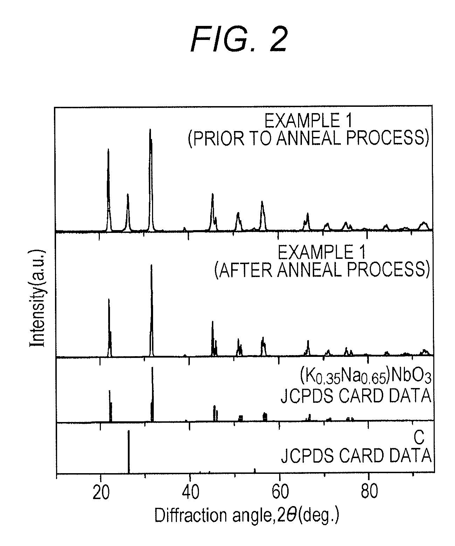

(1) The power generation element obtained in Example 1 was measured using an X-ray diffraction (XRD) device. The power generation element according to Example 1 was measured before and after the anneal process. The obtained XRD data are shown in FIG. 2 together with the JCPDS card data of carbon (C) and (K_{0.65}Na_{0.35}) NbO₃.

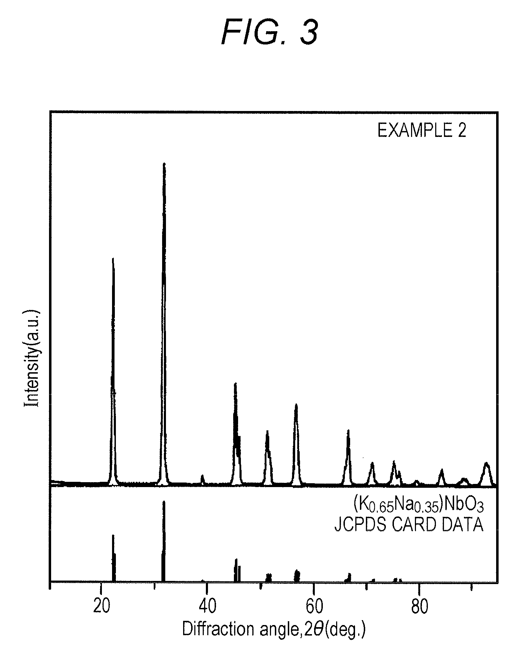

The power generation element obtained in Example 2 was also measured using the X-ray diffraction device. The obtained XRD data are shown in FIG. 3 together with the JCPDS card data of (K_{0.65}Na₀.₃₅) NbO₃. (2) The power generation element obtained in Example 1 was photographed by a FE-SEM (Field Emission-Scanning Electron Microscope) to analyze the surface of the element.

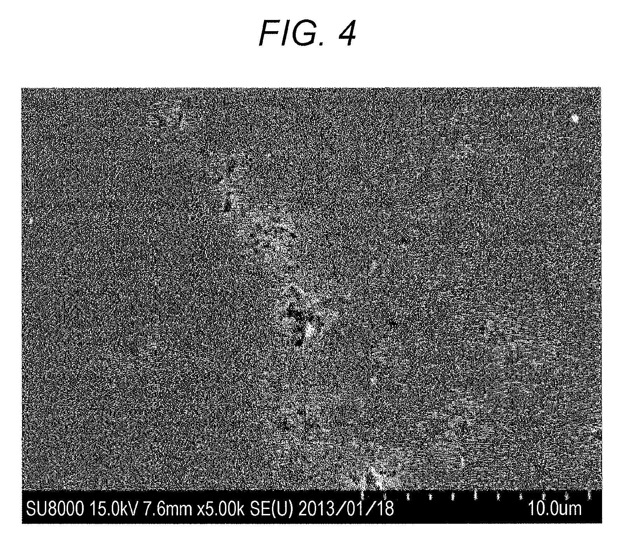

As a result, the apparent density was 4.40 g/cm³. The density is close to the theoretical density 4.46 g/cm³of (K_{1/2}Na_{1/2})NbO₃. The relative density was 99%. The obtained FE-SEM image is shown in FIG. 4.

The power generation element obtained in Example 2 was similarly subjected to the surface analysis. As a result, the apparent density was 4.51 g/cm³. The density is close to the theoretical density 4.46 g/cm³of (K_{1/2}Na_{1/2})NbO₃, The relative density was 98.4%.

### (3) Conclusion

From the XRD data and density, it was confirmed that the obtained power generation element included (K_{1/2}Na_{1/2})NbO₃.

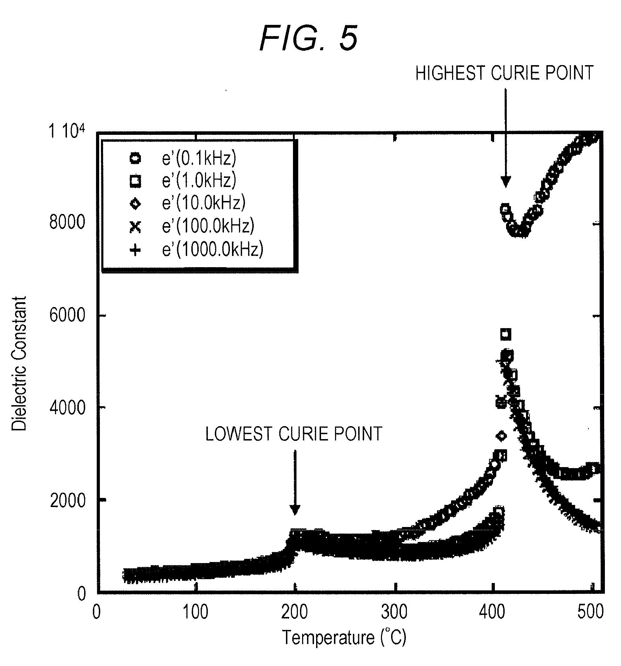

As illustrated in FIG. 5, in (K_{1/2}Na_{1/2})NbO₃, there are two Curie points at 200°C and 420°C (see "Preparation and characterization of (K0.5Na0.5)NbO3 ceramics", H. Birol et al./Journal of the European Ceramic Society 26 (2006) 861-866).

This is attributed to the fact that K_{1/2}Na_{1/2}NbO₃ has an orthorhombic system at normal temperature, a tetragonal system at 200°C or higher, and a cubic system at 420°C or higher, and that the crystal structure is gradually changed in accordance with the temperature. 2. The power generation element including K_{1/2}Na_{1/2}NbO₃ obtained in Example 1 was used as the first device (piezo element). The element was ground to the size of a thickness of 1.2 mm. Thereafter, gold ions were deposited on a front surface and a rear surface by gold sputtering for approximately 10 minutes, whereby gold electrodes (second device) were formed.

Thereafter, using an aluminum tape of 20 mm × 20 mm, one of two conductive wires (lead wires) was affixed onto each gold electrode. The other wire was connected to a digital multimeter.

As the heat source, a heat gun was used. The heat gun and the power generation element were disposed with the ejection opening of the heat source directed toward the power generation element and spaced 3 cm apart from the power generation element.

Hot air was ejected from the heat gun while switching on and off the heat gun over time, whereby the temperature of the heat gun and hot air was increased and decreased over time. By the temperature change, the temperature of the power generation element was increased and decreased over time, and the element was electrically polarized. Via the electrodes and conductive wires, a generated voltage (electric power) was obtained.

The temperature of the power generation element was measured with an infrared thermometer. The hot air temperature was adjusted so that the temperature of the power generation element included at least a part of a range of from 100°C (-100°C with respect to the lowest Curie point) to 450°C (+30°C with respect to the highest Curie point), and so that the amount of temperature change was approximately 50 to 80°C. Heating and radiational cooling were switched at the period of heating/radiational cooling = 10s/10s.

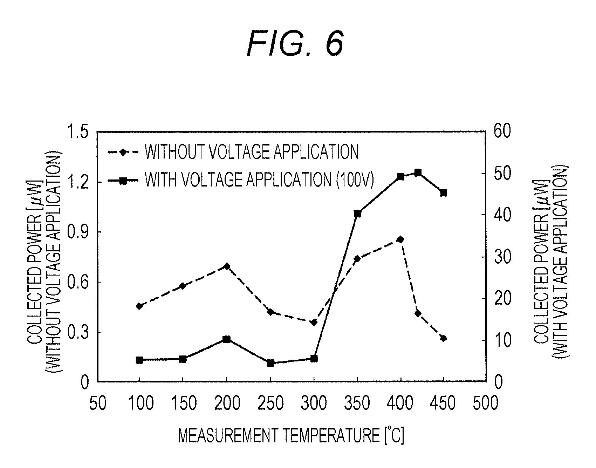

A voltage change in the electric power obtained from the power generation element was observed with a voltmeter. The relationship between the generated voltage and temperature change is illustrated in FIG. 6.

Further, a generated voltage (electric power) was obtained by the same method as described above with the exception that, as the heating and radiational cooling condition, the voltage application to the power generation element was performed by a voltage application device (Model 677B from Trek Japan Co. Ltd.) while the power generation element was being heated.

The intensity of the voltage was set to 100 V. During the heating of the power generation element (10 seconds per period), the time for which the application of 100V voltage was maintained (voltage application time) was set to 9.8 seconds per period. The relationship between the generated voltage and temperature change is also illustrated in FIG. 6.

This application is based on Japanese Patent Application No. 2013-205183 filed with the Japan Patent Office on September 30, 2013, the entire content of which is hereby incorporated by reference.

The description of specific embodiments of the present invention has been provided for illustrative purposes and is not intended to be exhaustive or limit the present invention to the precise forms disclosed. It should be obvious to those skilled in the art that numerous changes and modifications can be made in view of the contents of the foregoing descriptions.

## Claims

1. A power generation material represented by the following general formula (1):
(AₓB₁₋ₓ)NbO₃ (1)
wherein A and B are mutually different and represent at least one element selected from rare-earth elements, alkaline-earth metals, alkaline metals, Cd, and Bi, and x represents an atomic proportion in a numerical range of 0 < x ≤ 1.

2. The power generation material according to claim 1, wherein, in the general formula (1):
A is K;
B is Na; and
x is 1/2.

3. A power generation element comprising the power generation material according to claim 1 or 2.

4. A power generation system comprising:
a heat source of which a temperature is increased and decreased over time;
a first device including the power generation element according to claim 3 and configured to be electrically polarized by the temperature change of the heat source; and
a second device for obtaining electric power from the first device.
